# EUROPEAN PATENT SPECIFICATION

(11) **EP 0 817 246 B1**
(45) Date of publication and mention of the grant of the patent: **02.02.2005**
(21) Application number: 97870087.0
(22) Date of filing: 23.06.1997
(51) Int. Cl.: H01L 21/00

(54) **Apparatus and method for wet cleaning or etching of flat substrates**
Vorrichtung und Verfahren zur Nassreinigung oder zum Ätzen eines flachen Substrats
Appareil et méthode pour le nettoyage humide ou le gravure d'un substrat plat

(30) Priority: 24.06.1996 US 20060 P; 25.06.1996 US 20373 P; 20.12.1996 EP 96870162
(43) Date of publication of application: 07.01.1998
(73) Proprietor: INTERUNIVERSITAIR MICROELEKTRONICA CENTRUM VZW, 3001 Leuven (BE)
(72) Inventor: Meuris, Marc, 3140 Keerbergen (BE); Mertens, Paul, 2820 Bonheiden (BE); Heyns, Marc, 3210 Linden (BE)
(74) Representative: Van Malderen, Joelle

(56) References cited:
- EP-A- 0 407 044
- DE-A- 4 400 221

## Description

### Field of the invention

The present invention is related to the fabrication of flat substrates such as semiconductor wafers, flat panel displays, solar cells for microelectronics applications or of flat substrates for other applications which require a cleaning or etching step of said substrates during manufacturing.

The present invention relates more particularly to an apparatus and a method for wet cleaning or etching of said flat substrate.

### Background of the invention

In the processing of Semiconductor Wafers, the semiconductor surface preparation prior to various processing steps such as oxidation, deposition or growth processes, has become one of the most critical issues. With the rapid approach of subhalf micron design rules, very small particles with submicron dimensions and low levels of metal impurities (- 10¹⁰ atoms/cm²) can have a detrimental effect on process yields. A commonly used technique to reduce foreign particulate matter contamination level on semiconductor surfaces, is the immersion of wafers in liquids such as chemical solutions. The semiconductor wafers are usually placed into a tank or vessel or wet bench, which holds a liquid for cleaning or etching. Said tank or vessel or wet bench is installed in a clean room environment. Often a wet bench contains several vessels or tanks.

Semiconductor wafers or substrates can be immersed into the liquid from the upper part of the tank. Another way to achieve that the substrates are in contact with liquid is to use a door or an entrance at the side wall of the tank and to place a batch of wafers into the tank. After the door is closed and sealed, liquid is flowing into the tank, again to make contact between the cleaning or etching liquid and the substrates. In both approaches, one can switch from one liquid to the other liquid in the same tank. This method is commonly denominated as a single tank processor. Variations of these two techniques are also used for single wafer cleaning or etching purposes. In such a case, a wafer can be placed into a small vessel, which can be larger than the wafer. In some cases, the wafers are immersed into the liquid; in other cases, the wafers are loaded into an empty vessel and the liquid is flowing into the vessel.

A particular apparatus used after cleaning or etching of semiconductor wafers is disclosed in EP 0 385 536.

EP-A-407-044 discloses a system having two rooms containing each a liquid. The system can be used in a semiconductor wafer manufacturing line and allows a wafer to be transported from one room of the system to another room of the system without an intermixing of the liquids occurring. Hereto, the level of the liquids in the two rooms is adapted as to adjust the respective pressures of the liquids and an elaborate shutter device is provided in the system for opening and closing an opening between the two rooms without causing intermixing through flow and turbulence of the liquids.

A first drawback of the above-mentioned tools and methods is the footprint necessary, this means the surface area within a clean room occupied by the tank or vessel. Above-mentioned tools making use of a tank or vessel are big and occupy a large area within a clean room. It is to be understood that clean room area is very expensive due to the costs of maintaining an ultra-clean atmosphere.

Another drawback is the throughput of wafers. When e.g. a single tank processor is used, switching from one liquid to another liquid takes time and the system can have a lower throughput compared to a classical wet bench approach.

Another drawback of the prior art cleaning or etching tools and methods is that a non-uniformity in the cleaning or etching process occurs remains. This is to be understood as follows: when a wafer is dipped in a tank, the bottom part of the wafer is always remaining some longer in the cleaning or etching liquid than the upper part of the wafer. Therefore, the contact-time of several parts of the wafer is not identical.

A further drawback of the prior art cleaning or etching tools and methods is that a drying and/or rinsing step is required after a cleaning or etching step. This drying and/or rinsing step takes extra time and therefore increases the processing time of wafers.

### Aim of the invention

It is an aim of the present invention as claimed in claims 1 and 19 to provide an apparatus and a method for wet cleaning or etching a flat substrate wherein the above-mentioned drawbacks of the prior art tools and methods have less impact. The apparatus and the method of the present invention allow a high throughput of flat substrates and a high cycle time, allow a more uniform contact time for several parts of one wafer, allow the development of manufacturing systems with a small footprint and allow flat substrate manufacturing with the wet cleaning or etching step and the required drying procedure being executed in one processing step.

### Summary of the invention

The first object of the present invention is to provide an apparatus for wet cleaning or etching a flat substrate which comprises a tank with an opening for said substrate, said tank containing a cleaning or etching liquid and being installed in an environment consisting essentially of a gas or of a mixture of gases, such as a clean-room.

The said opening is present below the liquid-surface. The apparatus further comprises means to prevent the liquid from flowing through the opening out of the tank into the environment.

Advantageously, the substrate is transferred from within said environment into said apparatus through said opening. Said apparatus can be for instance used as part of a manufacturing line for the production of said flat substrate or as part of a manufacturing line for developing features in said substrate, such as integrated circuits in a silicon wafer.

In a first aspect of the apparatus according to the invention, said means are realized by the dimensions of the opening, said opening being such narrow that the liquid is prevented from flowing through it due to the surface tension and/or the capillary effect of said liquid.

A first embodiment of the apparatus to achieve this is characterized in that the opening is marginally larger than the thickness of said substrate and is, with respect to the thickness of the wall of the tanks, a lengthened passage.

A second embodiment of the apparatus to achieve this is characterized in that the opening is marginally larger than the thickness of said substrate and is towards the environment a converging passage.

In a second aspect of the present invention, said means comprise a portion in the tank, which portion is above the liquid and is filled with a gas or a gas mixture with a pressure being lower than the gas pressure within said environment. An advantageous embodiment of the apparatus to achieve this, is characterized in that said means comprise a pump connected with the room in the tank for sucking the gas and thereby reducing the gas-pressure in the tank and subsequently reducing the liquid-pressure near the opening.

In a third aspect of the apparatus of the invention, said means comprise a room adjacent to said tank, said room having an opening for said substrate and said room being filled with a gas or a gas mixture with a pressure being higher than the pressure within said environment. The wafer is transferred from said environment through said room into said tank.

In a fourth aspect of the apparatus according to the invention, said tank can be adjacent to a process chamber wherein, for instance, a gas phase etching process of semiconductor wafers can occur. In this embodiment, wafers are transferred from within said environment through said tank into said process chamber. In this way, the process chamber can be isolated from the environment thereby avoiding the introduction of moisture, oxygen or other rest gases in the chamber. Also, the introduction of a wafer into the process chamber through said tank can occur with a relatively simple automation setup. By preference, one tank is located adjacent to the process chamber at the inlet opening of said process chamber and another tank is located adjacent to the process chamber at the outlet opening of said process chamber. Said process chamber can be an etcher or a RTP-system or a EPI-system or another system being part of the manufacturing line of said substrate.

In a fifth aspect of the apparatus of the invention, said means comprise means outside the tank for directing a gas flow towards the opening. In an advantageous embodiment of the invention, the gas flow comprises N₂. In another embodiment the gas flow comprises a vapour which is not condensing on said substrate at said opening, said vapour being chosen from a group of substances which are miscible with said liquid and which will form with said liquid a mixture having a surface tension lower than that of said liquid alone. Preferably the vapour is an IPA vapour.

In a further aspect of the apparatus of the invention, said apparatus comprises an inlet opening and an outlet opening. Said inlet opening can be a slice in a first sidewall of said tank and said outlet opening can be in another wall of said tank, said substrate being passed essentially horizontally through said apparatus. In another embodiment said inlet opening is a slice in the bottom of said tank and said outlet opening is in the top of said tank, said substrates being passed essentially vertically through said apparatus.

Yet another embodiment of the apparatus according to the invention is characterized in that the tank further comprises an inlet and an outlet for said liquid, said outlet being near said opening and said means comprises a pump connected to the outlet for sucking the liquid and thereby reducing the liquid-pressure near the opening.

The invention furthermore pertains as a second object to a method of wet cleaning or etching a flat substrate in particular a semiconductor wafer, comprising the steps of putting a substrate via an opening in and out of a tank filled with a cleaning or etching liquid. The method in accordance with the invention is characterized in that the substrate is put into and/or taken out of the cleaning or etching liquid at a level underneath the liquid-surface via an opening in the tank present below the liquid-level in the tank and thereby preventing the liquid from flowing through the opening out of the tank.

More particularly, the method of wet cleaning or etching of a flat substrate in a tank filled with at least one cleaning or etching liquid comprises the steps of:
- loading from within a gaseous environment said substrate through an inlet opening in said tank, said inlet opening being at a level underneath the surface of said liquid; and
- unloading said substrate out of the tank into said gaseous environment while preventing said liquid from flowing out of said tank.

An embodiment of the method according to the invention is characterized in that, gas present above the liquid in the tank is sucked out of the tank to reduce the pressure inside the tank.

A further embodiment of the method according to the invention is characterized in that the liquid is sucked out of the tank near said opening to reduce the liquid-pressure near the opening.

Another embodiment of the method according to the invention is characterized in that a gas flow is directed towards said opening from outside the tank to dry the substrate and to prevent the liquid from flowing out of the tank.

The method of wet cleaning or etching a flat substrate comprises the step of transferring from within a gaseous environment said substrate through a tank filled with a cleaning or etching liquid, said substrate being introduced into said tank through an inlet opening and taken out of said tank through an outlet opening underneath the liquid-surface and are transferred at a uniform speed through said liquid thereby exposing essentially each part of said substrate to said liquid for the same time period.

Said apparatus and said method offer as an advantage the possibility of placing tanks no longer side by side but on top of each other. This approach makes it possible to reduce drastically the footprint of a cleaning or etching system and keeping a high throughput. Also a cleaning tank can be placed directly besides of a next apparatus for further processing. The footprint of the apparatus of the invention furthermore is much smaller than the footprint of a classical wet bench. At the same time the apparatus and method disclosed in the present application allow for keeping a high throughput. Said apparatus and said method offer as another advantage the possibility of achieving a uniform cleaning or etching of wafers being transferred through the cleaning or etching liquid in said tank. As wafers can be transferred at a uniform speed throughout said tank, each part of said wafers is exposed for the same time period to said cleaning or etching liquid. Another advantage of said apparatus and said method is that by the use of dilute chemical mixtures as a cleaning liquid in said tank, a rinsing step after said cleaning or etching step in said tank can be avoided. In this way, a fast processing time of wafers and a high throughput can be achieved. It is disclosed in the prior art that if a cleaning solution is dilute enough, being diluted preferably with DI-water, wafers may be dried immediately without ultra pure water rinsing after cleaning or etching. As a result, no detrimental residues are left behind on the wafer surface. This works well for instance with dilute HCl being diluted with DI-water in the range of pH 2 - 4. Another possibility is to have a very dilute SC1 cleaning step with a volume mixing ratio of NH₄OH/H₂O₂/H₂O in a range of about 1/1/1000. Another possible solution that can be used to achieve this purpose is to use ozonated water. A detailed description of the use of such dilute chemicals for wafer cleaning/rinsing purposes is given in the co-pending patent application EP 96309145.9 "Drying of Wafers Directly From Chemical Baths with No Ultra-Pure Water Rinse" being co-owned by IMEC and Texas Instruments.

It is to be understood that the apparatus and method disclosed in this document can be used for cleaning or etching of any kind of flat substrates. Thus, flat panel display substrates or solar cell substrates or glass substrates or metal plates or printed circuit boards can be cleaned or etched using a specific embodiment of the apparatus according to this invention.

### Brief description of the drawings

The invention will now be further elucidated on the basis of the example embodiments of the apparatus and method according to the invention, as depicted in the drawings. To this end:
Figure 1 provides a vertically cross-section view of a first embodiment of the apparatus according to the invention;
Figure 2 shows a horizontal cross-section of the apparatus according to the first embodiment;
Figure 3 shows a vertical cross-section of a detail of the apparatus near an opening according to the first embodiment;
Figure 4 shows another vertical cross-section of a detail of the apparatus near an opening;
Figure 5 provides a vertical cross-section view of a second embodiment of the apparatus according to the invention according to the second embodiment;
Figure 6 shows a horizontal cross-section of the apparatus according to the second embodiment;
Figure 7 shows the situation using another gas;
Figure 8 provides a vertically cross-section view of a third embodiment of the apparatus according to the invention;
Figure 9 provides a vertically cross-section view of a fourth embodiment of the apparatus according to the invention; and
Figure 10 shows a different mounting of the first embodiment of the apparatus.

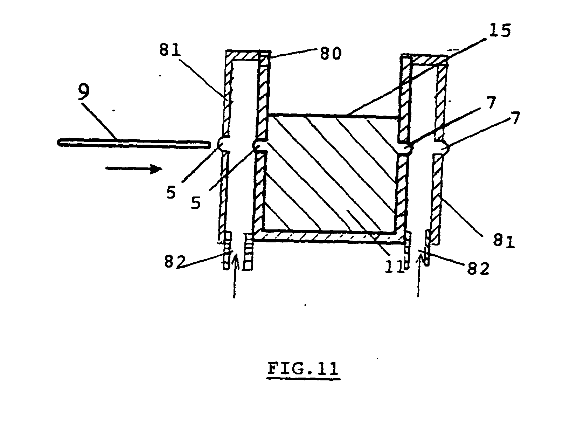

Figure 11 shows a specific embodiment of the apparatus of the present invention with a room at overpressure adjacent to said apparatus.

### Detailed description of preferred embodiments

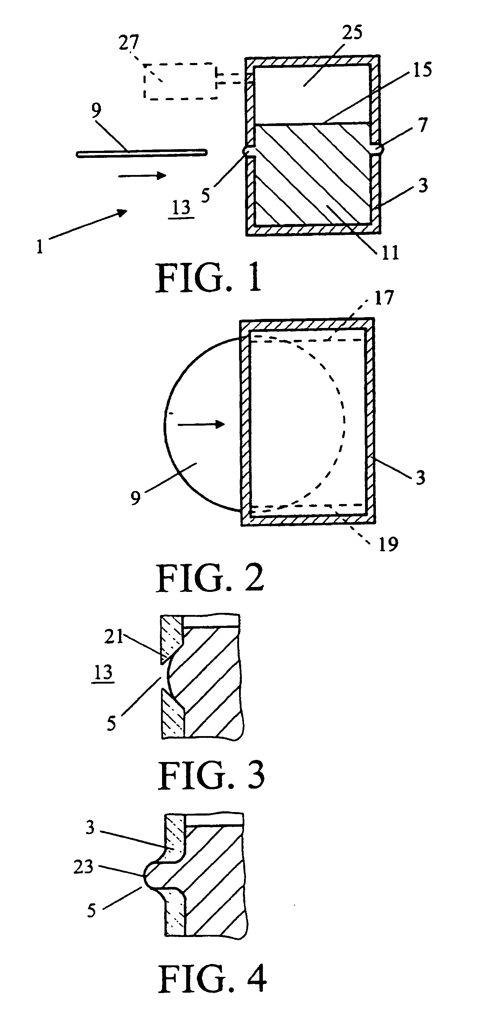

Figure 1 shows a first embodiment of the apparatus according to the invention for wet cleaning or etching of flat substrates, in particular semiconductor wafers. The apparatus 1 comprises a tank 3 with an inlet and an outlet opening 5, 7 for a substrate 9. The tank 3 containing cleaning or etching liquid 11 and being installed in a gaseous environment 13, for instance, a clean-room. The openings are present below the liquid-surface 15. The openings 5, 7 are such narrow that the liquid 11 is prevented from flowing through it due to the surface tension and/or the capillary effect of said liquid. Figure 2 shows a horizontal cross-section of the apparatus with the substrate 9 partly inserted in the tank 3 and sliding through the apparatus. At both sides the tank 3 contains guiding slits 17, 19 for the substrate transport.

In figures 3 and 4 improved shapes of the openings are shown for maximum prevention of leakage. In the embodiment of figure 3 the opening 5 has a tilted angle 21 and converges towards the environment 13. The opening is marginally larger than the thickness of the substrate. In the embodiment of figure 4 the opening 5 is lengthened with respect to the thickness of the wall of the tank 3.

The form of the meniscus 23 will also depend on the hydrophobicity of the tank wall material. It is possible that the tank wall material has to be treated in such a way that the contact angle versus the liquid, i.e. the surface tension of the material, has to stay stable during the operation of loading a flat substrate 9 in the tank 3.

Advantageously, the tank wall is made of a material that increases the capillary effect of said liquid. Such material can be a plastic.

The tank 3 comprises a portion 25 above the liquid 11 as can be seen in figure 1. This portion 25 is filled with a gas or a gas mixture with a pressure being lower than the pressure within the environment 13. To maintain this reduced pressure a pump 27 may be connected with the portion 25 for sucking the gas and thereby reducing the gas-pressure in the tank and subsequently reducing the liquid-pressure near the openings. This further prevents the liquid from flowing through the openings 5, 7 out of the tank 3. It is advantageous to regulate the pressure such that no air bubbles are sucked through the openings. The pressure in the portion 25 can be for instance 2 to 3 millibar below the pressure of the environment 13. The preferred pressure in the portion 25 is depending on the height of the liquid level above the openings 5, 7. The pressure advantageously is regulated such that the liquid in the tank is impeded from flowing out of the tank.

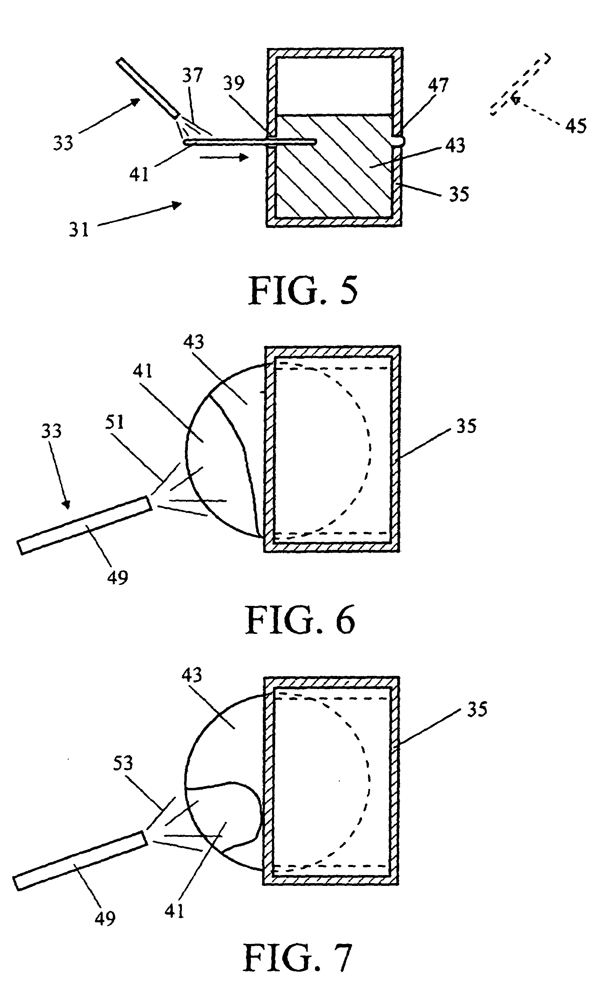

Figure 5 shows a second embodiment of the apparatus according to the invention. In this embodiment the apparatus 31 contains means 33 outside the tank 35 for directing a gas flow 37 towards the opening 39 to dry the substrate 41 and preventing the liquid 43 from flowing out of the tank 35. It is also possible to have further means 45 near the outlet opening 47. In the situation shown in figure 6 an IPA vapour is used. The means can comprise a tube 49 blowing a vapour comprising IPA possibly mixed with another gas. The inlet and/or outlet atmosphere of the tank can be saturated with said vapour. Using the vapour flow 51 over the outlet opening of the tank, the substrate 41 can be taken out dry. The marangoni effect is used to change the surface tension at the opening.

In the situation shown in figure 7, N₂ is used instead of the IPA vapour. One can observe a drying effect at the blow itself. So, one will have the choice to dry the substrate or with the force of a N₂ blow, or with the marangoni effect, or with a combination of both effects.

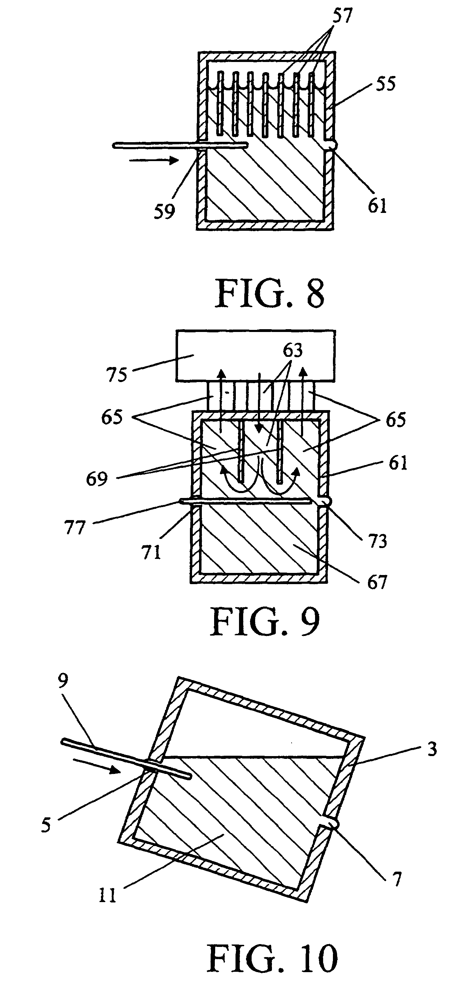

Another way to improve the apparatus of the invention is to make use of the capillary force to reduce the pressure at the inlet and outlet openings. This can be done by making use of vertical partitions which create a capillary force on the liquid by which the liquid is kept in the tank. In figure 8 this is shown in a third embodiment of the apparatus according to the invention. Inside the tank 55 there are partitions 57 to increase the capillary force and thereby reducing the liquid-pressure near the openings 59, 61.

A modification to this is the use of a tank of capillary dimension of only a few millimetres width (not shown in the drawings). The substrate is processed in a tank and a line of only a few millimetres width of liquid will touch the substrate. Another modification to this is the use of a tank with a height of only a few millimetres so that the liquid stays in by capillary force.

Another possibility is to make use of a pump to create a small differential pressure at the outlet and inlet openings towards the environment. This is shown in figure 9. The tank 61 comprises an inlet 63 and an outlet 65 for the cleaning or etching liquid 67. Vertical plates 69 are inserted to guide the flow as shown by the picture. A pump 75 is connected to the outlet for sucking the liquid and thereby reducing the liquid-pressure near the opening. When the plates 69 are sufficiently near the substrate 77 the velocity of the liquid will be sufficiently high close to the substrate surface to improve the supply of fresh solution.

In the above embodiments the inlet opening is a slice in the sidewall of the tank, the outlet opening is in another wall of the tank and the substrates being passed essentially horizontally through the apparatus. It is possible that only the outlet opening is under the liquid level, the outlet opening thus being in contact with the liquid and the inlet opening not being in contact with the liquid. It is also possible (not shown in the drawings) to make the inlet opening as a slice in the bottom of the tank and the outlet opening in the top of the tank, whereby the substrates being passed essentially vertically through the apparatus.

Another embodiment of the apparatus according to the invention has a room 81 adjacent to said tank 80, said room 81 having an opening for said substrates and said room 81 being filled with a gas or a gas mixture with a pressure being higher than the pressure within said environment, the pressure above said liquid in the tank 80 being equal to or lower than the pressure of said environment. The opening of said room 81 advantageously is at the same height as the opening of said tank 80.

A connection 82 is provided on said room 81 to allow making an overpressure in the room 81, preferentially by means of a gas flow being held at a pressure higher than the pressure of said environment.

Although the invention has been elucidated on the basis of the accompanying drawings in the discussion to this point, it should be noted that the invention is in no way restricted to just those embodiments depicted in the drawings. The invention also encompasses all the derivative embodiments which differ from the depicted embodiments within the scope defined in the claims. As an example, it is also possible to improve the inlet of the tank and facilitate the inlet of the substrate in the tank by tilting the device. This is shown in figure 10. This gives the potential that at the inlet no marangoni dry or other force will be necessary while placing the substrate in the device.

## Claims

1. Apparatus for wet cleaning or etching a flat substrate comprising a tank with an opening for said substrate, said opening being present below the liquid-surface, said tank containing in use at least one cleaning or etching liquid and being installed in an environment **characterized in that** said environment consists essentially of a gas or of a mixture of gases and said apparatus comprises means to prevent during operation said liquid from flowing through said opening out of said tank into said environment as a result of surface tension or capillary effect.

2. An apparatus as claimed in claim 1, **characterized in that** said means are realized by the dimensions of said opening, said opening being so narrow that the liquid is prevented from flowing through it due to the surface tension and/or the capillary effect of said liquid.

3. An apparatus as claimed in claim 2, **characterized in that** said opening is marginally larger than the thickness of said substrate.

4. An apparatus as claimed in claim 2, **characterized in that** said opening is marginally larger than the thickness of said substrate, said opening being with respect to the thickness of the wall of the tank a lengthened passage.

5. An apparatus as claimed in claim 2, **characterized in that** said opening is marginally larger than the thickness of said substrates said opening being towards said environment a converging passage.

6. An apparatus as claimed in claim 1, **characterized in that** said means comprise a room adjacent to said tank, said room having an opening for said substrates and said room being filled with a gas or gas mixture with a pressure being higher than the pressure within said environment.

7. An apparatus as claimed in claim 1, **characterized in that** said means comprise a second portion in the tank, said second portion being above said liquid and being filled with a gas or a gas mixture with a pressure being lower than the pressure within said environment.

8. An apparatus as claimed in claim 7, **characterized in that** said means comprise a pump connected with said second portion in the tank for sucking the gas, thereby reducing the gas-pressure in said second portion and subsequently reducing the liquid-pressure near said opening.

9. An apparatus as claimed in any one of the preceding claims, **characterized in that** said means comprise partitions inside the tank to increase the capillary force, thereby reducing the liquid-pressure near the opening.

10. An apparatus as claimed in any one of the preceding claims, **characterized in that** said liquid is a dilute chemical.

11. An apparatus as claimed in any one of the preceding claims, **characterized in that** the said means comprise means outside the tank for directing a gas flow towards said opening.

12. An apparatus as claimed in claim 11, **characterized in that** said gas flow comprises N₂ as a constituent of the gas flow mixture.

13. An apparatus as claimed in claim 11, **characterized in that** said gas flow comprises a vapour which is not condensing on said substrate at said opening, said vapour being chosen from a group of substances which are miscible with said liquid and which will form with said liquid a mixture having a surface tension lower than that of said liquid alone.

14. An apparatus as claimed in claim 13, **characterized in that** the vapour comprises IPA.

15. An apparatus as claimed in any one of the preceding claims, **characterized in that** said apparatus comprises an inlet opening and an outlet opening, said inlet opening being a slice in a first sidewall of said tank and said outlet opening being in a second wall of said tank, said substrate being passed essentially horizontally through said apparatus.

16. An apparatus as claimed in any one of the preceding claims, **characterized in that** said apparatus comprises an inlet opening and an outlet opening, said inlet opening being a slice in the bottom of said tank and said outlet opening being in the top of said tank, said substrate being passed essentially vertically through said apparatus.

17. An apparatus as claimed in any one the preceding claims, **characterized in that** said flat substrate is a semiconductor wafer and said environment is a clean room.

18. An apparatus as recited in claim 1, wherein said apparatus is adjacent to a process chamber being part of the manufacturing line of said substrate, said substrate being passed from within said apparatus into said process chamber.

19. Method of wet cleaning or etching of a flat substrate in a tank filled with at least one cleaning or etching liquid, said method comprising the steps of:
- loading said substrate in said tank at a level underneath the surface of said liquid from within a gaseous environment; and
- unloading said substrate out of the tank into said gaseous environment while preventing said liquid from flowing out of said tank, as a result of surface tension or capillary effect.

20. Method as claimed in claim 19, **characterized in that** a gas is present above the liquid in the tank, said gas being sucked out of the tank to reduce the pressure inside the tank.

21. Method as claimed in claim 19, **characterized in that** the liquid is sucked out of the tank to reduce the liquid-pressure near the opening.

22. Method as claimed in any one of the claims 19 to 21, **characterized in that** a gas flow is directed towards said opening from outside the tank, said gas flow drying the substrate and preventing the liquid from flowing out of the tank.

23. A method of wet cleaning or etching of flat substrates according to claim 19 comprising the step of transferring from within a gaseous environment said wafers through a tank filled with a cleaning or etching liquid **characterized in that** said substrates are introduced into said tank through an inlet opening and taken out of said tank through an outlet opening underneath the liquid-surface and are transferred at a uniform speed through said liquid thereby exposing essentially each part of said substrate to said liquid for the same time period.

## Patentansprüche

1. Gerät zum Nassreinigen oder Nassätzen eines flachen Substrates, welches einen Vorratsbehälter mit einer Öffnung für besagtes Substrat enthält, wobei besagte Öffnung sich unterhalb der Flüssigkeitsoberfläche befindet und wobei der besagte Vorratsbehälter im Betriebszustand mindestens eine Reinigungs- oder Ätzflüssigkeit enthält und in einer Umgebung installiert ist, **dadurch gekennzeichnet, dass** die besagte Umgebung hauptsächlich aus einem Gas oder aus einer Mischung von Gasen besteht, und dass besagtes Gerät Hilfsmittel enthält, um während des Betriebs zu verhindern, dass besagte Flüssigkeit als Folge einer Oberflächenspannung oder einer Kapillarwirkung durch besagte Öffnung aus besagtem Vorratsbehälter heraus in besagte Umgebung fließt.

2. Gerät gemäß Anspruch 1, **dadurch gekennzeichnet, dass** besagte Hilfsmittel aufgrund der Abmessungen der besagten Öffnung ausgeführt sind und dass die besagte Öffnung so schmal ist, dass die Flüssigkeit aufgrund der Oberflächenspannung und/oder der Kapillarwirkung besagter Flüssigkeit daran gehindert wird durch hindurch durch die Öffnung zu fließen.

3. Gerät gemäß Anspruch 2, **dadurch gekennzeichnet, dass** besagte Öffnung geringfügig größer ist als die Dicke des besagten Substrates.

4. Gerät gemäß Anspruch 2, **dadurch gekennzeichnet, dass** besagte Öffnung geringfügig größer ist als die Dicke des besagten Substrates, wobei besagte Öffnung in Bezug auf die Dicke der Wand des Vorratsbehälters einen aufgeweiteten Durchgang darstellt.

5. Gerät gemäß Anspruch 2, **dadurch gekennzeichnet, dass** besagte Öffnung geringfügig größer ist als die Dicke des besagten Substrates, wobei besagte Öffnung zur besagten Umgebung hin spitz zuläuft.

6. Gerät gemäß Anspruch 1, **dadurch gekennzeichnet, dass** besagte Hilfsmittel einen Raum unmittelbar neben dem besagten Vorratsbehälter enthalten, wobei besagter Raum eine Öffnung für besagte Substrate besitzt und besagter Raum mit Gas oder mit einer Gasmischung gefüllt ist, welche einen Druck aufweisen, der höher ist als der Druck innerhalb der besagten Umgebung.

7. Gerät gemäß Anspruch 1, **dadurch gekennzeichnet, dass** besagte Hilfsmittel in dem Vorratsbehälter einen zweiten Teil enthalten, wobei sich besagter zweiter Teil über besagter Flüssigkeit befindet und mit einem Gas oder mit einem Gasgemisch gefüllt ist, wobei dieser zweite Teil einen Druck aufweist, der geringer ist als der Druck innerhalb besagter Umgebung.

8. Gerät gemäß Anspruch 7, **dadurch gekennzeichnet, dass** besagte Hilfsmittel eine Pumpe enthalten, die mit besagtem zweiten Teil in dem Tank verbunden ist, um das Gas anzusaugen und dadurch den Gasdruck in besagtem zweiten Teil zu verringern und anschließend den Flüssigkeitsdruck in der Nähe besagter Öffnung zu verringern.

9. Gerät gemäß irgendeinem der vorausgehenden Ansprüche, **dadurch gekennzeichnet, dass** besagte Hilfsmittel Unterteilungen innerhalb des Vorratsbehälters enthalten, um die Kapillarkraft zu erhöhen, und um dadurch den Flüssigkeitsdruck in der Nähe der Öffnung zu verringern.

10. Gerät gemäß irgendeinem der vorausgehenden Ansprüche, **dadurch gekennzeichnet, dass** besagte Flüssigkeit eine verdünnte Chemikalie ist.

11. Gerät gemäß irgendeinem der vorausgehenden Ansprüche, **dadurch gekennzeichnet, dass** besagte Hilfsmittel außerhalb des Vorratsbehälters ein Hilfsmittel enthalten, das eine Gasströmung in Richtung auf die besagte Öffnung lenkt.

12. Gerät gemäß Anspruch 11, **dadurch gekennzeichnet, dass** besagte Gasströmung N₂ als Bestandteil der strömenden Gasmischung enthält.

13. Gerät gemäß Anspruch 11, **dadurch gekennzeichnet, dass** besagte Gasströmung einen Dampf enthält, der auf besagtem Substrat an besagter Öffnung nicht kondensiert, wobei besagter Dampf aus der Gruppe von Stoffen ausgewählt wurde, die mit besagter Flüssigkeit mischbar sind und die mit besagter Flüssigkeit eine Mischung bilden, die eine geringere Oberflächenspannung als diejenige der besagten Flüssigkeit alleine aufweist.

14. Gerät gemäß Anspruch 13, **dadurch gekennzeichnet, dass** der Dampf einen IPA enthält.

15. Gerät gemäß irgend einem der vorausgehenden Ansprüche, **dadurch gekennzeichnet, dass** besagtes Gerät eine Einlassöffnung und eine Auslassöffnung enthält, wobei besagte Einlassöffnung aus einem Schlitz in einer ersten Seitenwand des besagten Vorratsbehälters besteht und wobei besagte Auslassöffnung sich in einer zweiten Wand des besagten Vorratsbehälters befindet, und wobei besagtes Substrat im wesentlichen waagerecht durch besagtes Gerät hindurch geschoben werden kann.

16. Gerät gemäß irgendeinem der vorausgehenden Ansprüche, **dadurch gekennzeichnet, dass** besagtes Gerät eine Einlassöffnung und eine Auslassöffnung enthält, wobei besagte Einlassöffnung aus einem Schlitz im Boden des besagten Vorratsbehälters besteht und wobei sich besagte Auslassöffnung ganz oben in besagtem Vorratsbehälter befindet, so dass das besagte Substrat im wesentlichen in vertikaler Richtung durch besagtes Gerät geschoben werden kann.

17. Gerät gemäß irgendeinem der vorausgehenden Ansprüche, **dadurch gekennzeichnet, dass** besagtes flaches Substrat ein Halbleiter-Wafer und besagte Umgebung ein Reinraum ist.

18. Gerät gemäß Anspruch 1, wobei sich besagtes Gerät unmittelbar neben einer Prozesskammer befindet, die einen Teil des Fertigungsbandes des besagten Substrates darstellt, wobei besagtes Substrat von innerhalb des besagten Geräts aus in besagte Prozesskammer hinein geschoben wird.

19. Verfahren zur Nassreinigung oder zum Nassätzen eines flachen Substrates in einem Vorratsbehälter, der mit mindestens einer Reinigungs- oder einer Ätzflüssigkeit gefüllt ist, wobei besagtes Verfahren die folgenden Einzelschritte enthält:
- Einschieben des besagten Substrats aus einer gasförmigen Umgebung kommend in besagten Vorratsbehälter in einer Höhe unterhalb der Oberfläche der besagten Flüssigkeit; und
- Herausnehmen des besagten Substrats aus dem Vorratsbehälter in besagte gasförmige Umgebung hinein, während ein Herausfließen besagter Flüssigkeit aus besagtem Vorratsbehälter als eine Folge einer Oberflächenspannung oder einer Kapillarwirkung somit verhindert wird.

20. Verfahren gemäß Anspruch 19, **dadurch gekennzeichnet, dass** sich über der Flüssigkeit in dem Vorratsbehälter ein Gas befindet, wobei besagtes Gas aus dem Vorratsbehälter herausgesaugt wird, um den Druck im Innern des Vorratsbehälters zu verringern.

21. Verfahren gemäß Anspruch 19, **dadurch gekennzeichnet, dass** die Flüssigkeit aus dem Vorratsbehälter herausgesaugt wird, um den Flüssigkeitsdruck in der Nähe der Öffnung zu verringern.

22. Verfahren gemäß irgendeinem der Ansprüche 19 bis 21, **dadurch gekennzeichnet, dass** eine Gasströmung von außerhalb des Vorratsbehälters in Richtung auf die besagte Öffnung gelenkt wird, wobei besagte Gasströmung das Substrat trocknet und die Flüssigkeit daran gehindert wird, aus dem Vorratsbehälter herauszufließen.

23. Verfahren zum Nassreinigen oder zum Nassätzen eines flachen Substrats gemäß Anspruch 19, welches den Schritt enthält, bei dem von der gasförmigen Umgebung ausgehend besagte Wafer durch einen Vorratsbehälter geschoben werden, der mit einer Reinigungs- oder Ätzflüssigkeit gefüllt ist, **dadurch gekennzeichnet, dass** besagte Substrate in besagten Vorratsbehälter durch eine Einlassöffnung eingeführt werden und durch eine Auslassöffnung unterhalb der Flüssigkeitsoberfläche aus besagtem Vorratsbehälter herausgenommen und mit einer gleichmäßigen Geschwindigkeit durch besagte Flüssigkeit hindurch geführt werden, wobei somit im wesentlichen ein jeder Teil des besagten Substrates während der gleichen Zeitdauer der besagten Flüssigkeit ausgesetzt ist.

## Revendications

1. Appareil pour le nettoyage ou la gravure humide d'un substrat plat comprenant un réservoir avec une ouverture pour ledit substrat, ladite ouverture étant présente en dessous de la surface du liquide, ledit réservoir contenant pendant l'utilisation au moins un liquide de nettoyage ou de gravure et étant installé dans un environnement **caractérisé en ce que** ledit environnement est constitué essentiellement d'un gaz ou d'un mélange de gaz et ledit appareil comprend un moyen pour empêcher durant l'opération ledit liquide de s'écouler par ladite ouverture hors dudit réservoir dans ledit environnement, à la suite d'une tension superficielle ou d'un effet capillaire.

2. Appareil selon la revendication 1, **caractérisé en ce que** ledit moyen est réalisé par les dimensions de ladite ouverture, ladite ouverture étant si étroite que le liquide est empêché de s'écouler par elle, en raison de la tension superficielle et/ou de l'effet capillaire dudit liquide.

3. Appareil selon la revendication 2, **caractérisé en ce que** ladite ouverture est légèrement plus grande que l'épaisseur dudit substrat.

4. Appareil selon la revendication 2, **caractérisé en ce que** ladite ouverture est légèrement plus grande que l'épaisseur dudit substrat, ladite ouverture étant un passage rallongé par rapport à l'épaisseur de la paroi du réservoir.

5. Appareil selon la revendication 2, **caractérisé en ce que** ladite ouverture est légèrement plus grande que l'épaisseur desdits substrats, ladite ouverture étant un passage convergent vers ledit environnement.

6. Appareil selon la revendication 1, **caractérisé en ce que** ledit moyen comprend une chambre adjacente audit réservoir, ladite chambre possédant une ouverture pour lesdits substrats et ladite chambre étant remplie d'un gaz ou d'un mélange de gaz avec une pression qui est supérieure à la pression dans ledit environnement.

7. Appareil selon la revendication 1, **caractérisé en ce que** ledit moyen comprend une deuxième partie dans le réservoir, ladite deuxième partie étant au-dessus dudit liquide et étant remplie d'un gaz ou d'un mélange de gaz avec une pression qui est inférieure à la pression dans ledit environnement.

8. Appareil selon la revendication 7, **caractérisé en ce que** ledit moyen comprend une pompe connectée à ladite deuxième partie dans le réservoir pour aspirer le gaz, réduisant ainsi la pression de gaz dans ladite deuxième partie et réduisant ensuite la pression de liquide près de ladite ouverture.

9. Appareil selon l'une quelconque des revendications précédentes, **caractérisé en ce que** ledit moyen comprend des cloisons à l'intérieur du réservoir pour augmenter la force capillaire, réduisant ainsi la pression de liquide près de l'ouverture.

10. Appareil selon l'une quelconque des revendications précédentes, **caractérisé en ce que** ledit liquide est un produit chimique dilué.

11. Appareil selon l'une quelconque des revendications précédentes, **caractérisé en ce que** ledit moyen comprend un moyen à l'extérieur du réservoir pour diriger un écoulement de gaz vers ladite ouverture.

12. Appareil selon la revendication 11, **caractérisé en ce que** ledit écoulement de gaz comprend N₂ comme constituant du mélange de l'écoulement de gaz.

13. Appareil selon la revendication 11, **caractérisé en ce que** ledit écoulement de gaz comprend une vapeur qui ne se condense pas sur ledit substrat au niveau de ladite ouverture, ladite vapeur étant choisie dans un groupe de substances qui sont miscibles avec ledit liquide et qui formeront avec ledit liquide un mélange présentant une tension superficielle inférieure à celle dudit liquide seul.

14. Appareil selon la revendication 13, **caractérisé en ce que** la vapeur comprend de l'IPA.

15. Appareil selon l'une quelconque des revendications précédentes, **caractérisé en ce que** ledit appareil comprend une ouverture d'entrée et une ouverture de sortie, ladite ouverture d'entrée étant une tranche dans une première paroi latérale dudit réservoir et ladite ouverture de sortie étant dans une deuxième paroi dudit réservoir, ledit substrat étant passé essentiellement horizontalement à travers ledit appareil.

16. Appareil selon l'une quelconque des revendications précédentes, **caractérisé en ce que** ledit appareil comprend une ouverture d'entrée et une ouverture de sortie, ladite ouverture d'entrée étant une tranche dans le fond dudit réservoir et ladite ouverture de sortie étant dans le haut dudit réservoir, ledit substrat étant passé essentiellement verticalement à travers ledit appareil.

17. Appareil selon l'une quelconque des revendications précédentes, **caractérisé en ce que** ledit substrat plat est une rondelle de semi-conducteur et ledit environnement est une salle blanche.

18. Appareil selon la revendication 1, où ledit appareil est adjacent à une chambre de procédé qui fait partie de la chaîne de fabrication dudit substrat, ledit substrat étant passé depuis l'intérieur dudit appareil dans ladite chambre de procédé.

19. Procédé pour le nettoyage ou la gravure humide d'un substrat plat dans un réservoir rempli d'au moins un liquide de nettoyage ou de gravure, ledit procédé comprenant les étapes:
- de chargement dudit substrat dans ledit réservoir à un niveau en dessous de la surface dudit liquide depuis l'intérieur d'un environnement gazeux; et
- de déchargement dudit substrat hors du réservoir dans ledit environnement gazeux tout en empêchant ledit liquide de s'écouler hors dudit réservoir, à la suite d'une tension superficielle ou d'un effet capillaire.

20. Procédé selon la revendication 19, **caractérisé en ce qu'**un gaz est présent au-dessus du liquide dans le réservoir, ledit gaz étant aspiré hors du réservoir pour réduire la pression à l'intérieur du réservoir.

21. Procédé selon la revendication 19, **caractérisé en ce que** le liquide est aspiré hors du réservoir pour réduire la pression de liquide près de l'ouverture.

22. Procédé selon l'une quelconque des revendications 19 à 21, **caractérisé en ce qu'**un écoulement de gaz est dirigé vers ladite ouverture depuis l'extérieur du réservoir, ledit écoulement de gaz séchant le substrat et empêchant le liquide de s'écouler hors du réservoir.

23. Procédé pour le nettoyage ou la gravure humide de substrats plats selon la revendication 19, comprenant l'étape de transfert depuis l'intérieur d'un environnement gazeux desdites rondelles à travers un réservoir rempli d'un liquide de nettoyage ou de gravure **caractérisé en ce que** lesdits substrats sont introduits dans ledit réservoir par une ouverture d'entrée et enlevés dudit réservoir par une ouverture de sortie en dessous de la surface de liquide et sont transférés à une vitesse uniforme à travers ledit liquide, exposant ainsi essentiellement chaque partie dudit substrat audit liquide pendant la même période de temps.
